# EUROPEAN PATENT SPECIFICATION

(11) **EP 0 712 164 B1**
(45) Date of publication and mention of the grant of the patent: **02.07.2003**
(21) Application number: 96101001.4
(22) Date of filing: 18.04.1990
(51) Int. Cl.: H01L 27/118

(54) **Semiconductor device**
Halbleiteranordnung
Dispositif semi-conducteur

(30) Priority: 19.04.1989 JP 9913089; 19.05.1989 JP 12583989; 07.02.1990 JP 2778590
(43) Date of publication of application: 15.05.1996
(62) Divisional of application: 90107341.1
(73) Proprietor: SEIKO EPSON CORPORATION, Shinjuku-ku Tokyo-to (JP)
(72) Inventor: Sakuda, Takashi, Suwa-shi, Nagano-ken (JP); Ohkawa, Kazuhiko, Suwa-shi, Nagano-ken (JP); Oguchi, Yasuhiro, Suwa-shi, Nagano-ken (JP); Hirabayashi, Yasuhisa, Suwa-shi, Nagano-ken (JP)
(74) Representative: Hoffmann, Eckart, Dipl.-Ing.

(56) References cited:
- PATENT ABSTRACTS OF JAPAN vol. 010, no. 192 (E-417), 5 July 1986 & JP-A-61 035535 (FUJITSU LTD), 20 February 1986,
- THE PROCEEDINGS OF THE 1ST INTERNATIONAL CONFERENCE ON SEMI-CUSTOM IC'S, November 1981, LONDON GB, pages 65-74, XP002011033 T. GILES: "Philips PCF700 series LOCMOS gate arrays"

## Description

### BACKGROUND OF THE INVENTION

### Field of the Invention

The present invention relates to semiconductor devices. More specifically, the present invention pertains to semiconductor devices which comprise closely spaced gate arrays having a plurality of unit semiconductor devices of gate-separated type insulated-gate field-effect transistors, the gates of which have an improved configuration.

### Related Art Description

Conventional semiconductor chip products of the channelless gate array type have such an inner layout as shown in Figure 8, in which a matrix of a plurality of gate-separated type unit semiconductor devices 2 is disposed on a silicon chip substrate 1 with a plurality of input/output buffer portions B along the peripheral area of the chip substrate so that they surround the matrix of the unit devices. Figure 9 illustrates a portion of the matrix in an enlarged scale. In this type of gate array, insulated-gate field-effect transistors in the same unit devices are connected with each other and/or those belonging to different unit devices are connected by means of a first and/or second layers of aluminum wire deposited on the gate array, so that a desired large-scale logic circuitry can be obtained.

Figure 10 is a block diagram of the unit device of the gate-separated type. The unit device 2 is comprised of two pairs of complementary insulated-gate field-effect transistors 2a and 2b of the gate-separated type ( hereinafter referred to as "CMOSFET"). The gates G of the CMOSFETs are independent of one another, whereas the FETs of the same conductivity type have a common drain D or source S. Figure 11 illustrates a conventional structure of the gate-separated unit device 2. As shown in this Figure, an N-type substrate is formed with a rectangular-shaped region of a P-type well 3 which is formed by diffusing P-type impurities in the substrate. Polysilicon gates 4N, 5N are formed in the P-type well 3 via a gate oxide film so that they are across the P-type well and are symmetrical with each other. Adjacent to the P-type well 3 another pair of polysilicon gates 4P and 5P are formed at the parallel moved positions of the respective gates 4N and 5N in the channel width direction. A heavily diffused N-type region 6 is formed in a self-aligned manner by ion implantation of N-type impurities into the P-type well with utilization of the pair of polysilicon gates 4N and 5N. Likewise, heavily diffused P-type region 7 is formed in a self-aligned manner by ion implantation of P-type impurities into the N-type substrate with utilization of the pair of polysilicon gates 4P and 5P. In addition, a heavily doped P-type stopper 8 is provided by diffusion adjacent to the region 6 in order to supply voltage V_{DD} to the N-type substrate, and a heavily doped N-type stopper 9 is disposed adjacent to the region 7, the stopper 9 being for supplying voltage V_{SS} to the P well.

Each of the polysilicon gates 4N, 5N, 4P and 5P are of the U-shaped configuration comprising a narrow width gate electrode portion g and rectangular gate output terminal portions T1 and T2 extended form the both ends of the gate electrode portion g. Regions just below the respective gate electrode portions g function as channels. Region, which is located in the heavily diffused N-type region 6 between the parallel disposed gate electrode portions g, functions as a common drain or source region for the two N-channel MOSFETs. The common drain or source region for the two P-channel MOSFET is likewise located between the parallel disposed gate electrode portions g in the heavily diffused P-type region 7.

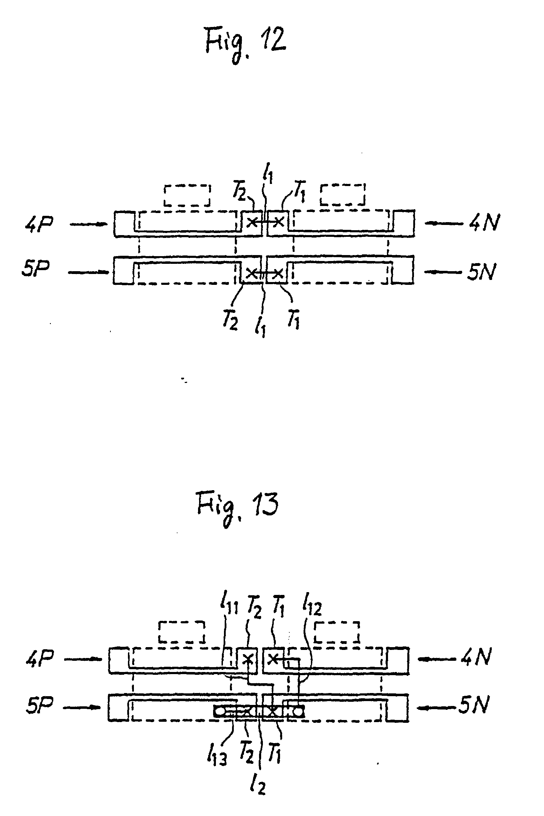

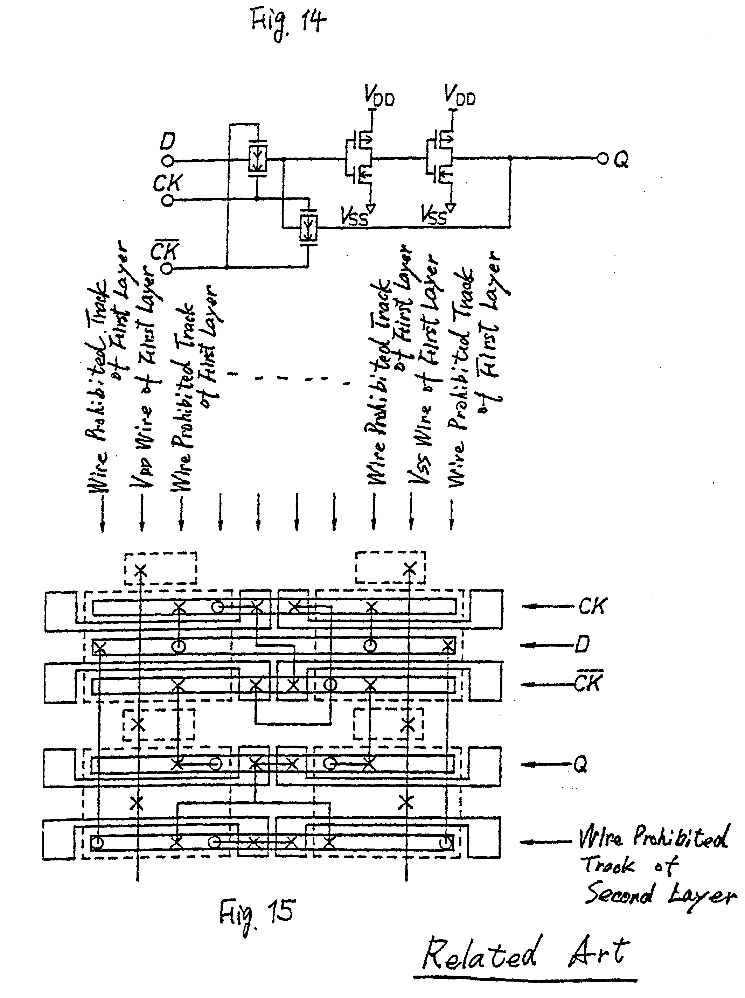

In the gate array of the above-mentioned gate-separated unit devices 2, as shown in Figure 12, the adjacent CMOSFETs of the same unit device are wired between their gates oppositely arranged with each other so that the gate output terminal portions T1 and T2 thereof are connected via the aluminum wire 11 (shown by solid line) of a first layer through contact holes ( denoted by "X" in the drawing), said the first layer being laid on the gates, whereby the shortest wire-connection between the adjacent CMOSFETs can be achieved. The diagonal wire connection between terminal portions T1 and T2 in the same unit device can be obtained as shown in Figure 13, wherein one pair of diagonally positioned terminal portions T1 and T2 are connected by means of the aluminum wire l11 of a first layer through contact holes. Whereas, the other pair of diagonally positioned terminal portions T1 and T2 are connected by means of aluminum wires l12 and l13 of the first layer and the aluminum wire l2 (shown by double solid line) of a second layer laid on the first layer through contact holes and connecting portions denoted by "O". The separated-type unit device has benefits that it can easily be modified to a common-gate type unit device by such a wiring as shown in Figure 12 and that it can be applied with the diagonal wiring as shown in Figure 13 which is not applicable to the common-gate type unit device. Especially, the applicability of the diagonal wiring is useful to compose functional devices such as transmission gates and the like.

However, the diagonal wiring requires a second or more layered aluminum wires in the case that the wire length is intended to be as short as possible. If the second layered aluminum wires l2 are arranged for connection among the elements within the unit devices, the regions occupied by these second layered wires cannot be utilized to arrange another wires for connection among the remotely positioned functional unit devices and among the functional unit devices and the input/output buffers, thus those regions are called a "wire prohibited track". Therefore, outer wiring feasibility (defined as ease of wiring among the remotely positioned functional unit devices and among the functional unit devices and the input/output buffers) becomes degraded as the number or area of the inner wires of the second or more layers increases. For example, a D flip-flop shown in Figure 14 can be constituted by two unit devices 2. In this case, "wire prohibited tracks" occur on the second layer of aluminum as shown in Figure 15 due to the diagonal wiring among the inner elements, so that the outer wiring feasibility becomes degraded.

It is of course possible that the two unit devices can be connected without using second layered aluminum wires. However, in this case, the respective aluminum wires of the first layer must be arranged so that they do not cross one another, which means that the total wire length becomes longer, so that the occupied regions for those long wires becomes larger. This degrades inner wiring feasibility (defined as ease of wiring among the elements in each of the unit devices and among the adjacent unit devices). If the first layered wires become complicated and elongated, wire resistance and wire capacity caused by increase of wired area will increase, and so wire time constant will become larger. This will cause a noticable amount of delay in the device operation.

The document Patent Abstracts of Japan, Vol.10, No.192 (E-417)[2248], July 1986 (& JP-A-61-35535) discloses a semiconductor device according to the precharacterizing portion of claim 1. In this prior art each of the first and third gate terminal portions has first and second wire connecting portions integrally connected with each other. One of source and drain regions of said first transistor, said first gate terminal portion and one of source and drain regions of said second transistor are arranged on a first straight line. The other one of source and drain regions of said first transistor, the third and the fourth gate terminal portion and the other one of source and drain regions of said second transistor are arranged on a second straight line parallel to said first line. The first wire connecting portion of the first transistor and the second wire connecting portion of the second transistor are arranged on a third straight line perpendicular to the first and second lines. The second wire connecting portion of the first transistor and the first wire connecting portion of the second transistor are arranged on a fourth straight line in parallel to the third line. Each unit semiconductor device comprises two pairs of such first and second transistors the two pairs being axially symmetrical with respect to an axis parallel to said first and second straight lines.

The document The Proceedings of the 1st International Conference on Semi-Custom IC's, London, Nov. 1981, pages 65-74 discloses another semiconductor device according to the precharacterizing portion of claim 1. In this prior art the third gate terminal portion has first, second and third wire connecting portions integrally connected with each other. The first gate terminal portion and a first wire connecting portion of the third gate terminal portion are arranged on a first straight line. The second and third wire connecting portions of the third gate terminal portion are arranged on a second straight line parallel to said first line. The first gate terminal portion and the third wire connecting portion of the third gate terminal portion are arranged on a third straight line perpendicular to said first and second lines. The first and second wire connecting portions of the third gate terminal portion are arranged on a fourth straight line parallel to said third line.

### SUMMARY OF THE INVENTION

Accordingly, it is an object of the present invention to provide a unit semiconductor device of the gate-separated type of which gates are designed to have an improved profile, whereby adjacent gates in the unit device can be diagonally connected by using first layered wires only without increase of the wire length.

It is an another object of the present invention to provide a semiconductor device which comprises a gate array of a plurality of unit semiconductor devices having gates of an improved profile to thereby enhance the inner wiring feasibility thereof as well as the outer wiring feasibility.

These objects are achieved with a semiconductor device as claimed in claim 1. Preferred embodiments of the invention are subject-matter of the dependent claims.

The respective gate electrodes are usually made by polysilicon in consideration of self-alinged formation of the source or drain regions. The remaining region of the semiconductor substrate, which does not contribute substantially to the formation of a channel inverted layer, is utilized as the site on which gate terminal portions of the gate electrodes are disposed. The gate terminal portions can be a layer deposited on the layer of the gate electrodes, which, however, requires another process in addition to the gate electrode forming process. Hence, it is recommendable to form the gate terminal portions in the same layer of the gate elecrtrodes at the same time the gate electrodes are formed.

Typical semiconductor devices of master slice layout are provided with gate electrodes designed to have a profile of short channel length and wide channel width in order to decrease on-resistance value. On the other hand, automatic wiring process is usually utilized to connect among the elements in the unit devices and among the unit devices, wherein wires are arranged along the longitudinal and lateral directions of the grids, and therefore the first and second insulated-gate field-effect transistors are needed to arrange such that the channel regions (the gate electrodes) of the respective transistors are oriented in the same direction, either the longitudinal direction or the lateral direction of the grids. The channel regions of the respective transistors may be arranged between the same longitudinal or the same lateral line of the grids, or they may be in the adjacent, parallel grid lines, respectively.

As mentioned above, the gate terminal portions are formed on regions other than those for source or drain, and the gate electrodes are usually of a narrow width shape. The gate terminal portions formed at both ends of the gate electrode are wide in the channel length direction compared to the gate electrode. In this case, the gate terminal portions are generally designed to have a minimum area of one-grid square.

The first insulated-gate type field-effect transistor is formed with gate terminal portions of a crank shape, wherein each of the gate terminal portions has a first wire connecting portion positioned adjacent to the gate electrode and a second wire connecting portion extending from the first wire connecting portion in a manner to form the crank shape. In addition, the crank-shaped terminal portion has a connecting portion between the first and the second wire connecting portions, and the third portion may be another wire connecting portion as required.

In a preferred embodiment of the present invention, the gate terminal portions of the first insulated-gate type field-effect transistor are formed to be a rectangular shape, wherein a first terminal portion is positioned adjacent to an end of the gate electrode and a second terminal portion is formed extending form the outer edge of the first terminal portion. The gate terminal portion of this shape occupies at least an area of two-grid.

In this type of gate terminal portion, the first wire connecting portion is used to be connected with wires arranged along a longitudinal and lateral grid lines, respectively. The second terminal portion is also used to be connected with a longitudinal and lateral wires, either one of which is the same one as either one of the wires capable of being connected with the first terminal portion. While, in the case of the above-mentioned crank-shaped terminal portion, wires connectable with the first terminal portions are different from those which are able to be connected with the second terminal portions.

It is apparent that inner and outer wiring feasibilities are improved as the number of wires which can be connected with the gate terminal portions. The increase in the number of wires, however, means that the gate terminal portions become an increased area, which causes degradation in element-integrity of semiconductor devices. In automatic wiring of the gate terminal portions, wires are arranged along the longitudinal and lateral grid lines. Therefore, the gate terminal portions are preferably designed such that they are able to be connected with wires of different grid lines. Thus, in a preferred embodiment of the present invention, there is provided a semiconductor device wherein gate electrodes of unit semiconductor devices are formed at one end with a gate terminal portion of rectangular shape, charecterized in that wire junction portions are provided in the regions surrounded by four gate terminal portions, each of the wire junction portions having an area of at least three-grid. The wire junction portions are preferably formed in the same layer of the gate electrodes by polysilicon or the like.

According to the present invention, each of the gate terminal portions comprises the second wire connecting portion as well as the first wire connecting portion. The second connecting portions can be, for example, used to connect wires of the first layer through contact holes, by which wire length can be reduced in comparison with using only the first connecting portions for wiring. Hence, the unit devices can be diagonally connected as described before, using wires of only the first layer in such a manner that the wire length is not increased. By this short wiring, the delayed time caused by the wiring is reduced, and the inner wiring feasibility is improved. In addition, since the second connecting portions can be utilized for passage of wires of the first layer, wires of the second layer are required in less number, and wire prohibited tracks are reduced in number, whereby the outer wiring feasibility can be enhanced.

Where the gate terminal portions are of a crank shape, the diagonal wiring among the gate terminal portions can be achieved by using only wires of the first layer arranged within the areas on the adjacent gate terminal portions.

While, where the gate terminal portions are of the rectangular shape and the wire-junction portions are provided, the diagonal wiring among the gates is carried out by connecting wires of the first layer to the both ends of the wire-junction portions via contact holes, while other wires of the first layer can be arranged to pass on the middle of the wire-junction portions. According to the arrangement, wires of the first layer which are required for the diagonal wiring do not project onto the source or drain regions. In addition, where the adjacent gate terminal portions are connected, it is possible to make a space between the wires connecting gate terminal portions. The space can be utilized to arrange other wires of the first layer.

### BRIEF DESCRIPTION OF THE DRAWINGS

The above and other objects and advantages of the present invention will be apparent from the following detailed description with reference to the attached drawings, in which:
- Figure 1: is a diagram illustrating an array of gate-separated type unit devices of a first embodiment of the present invention;
- Figure 2: is a plan view of the unit device in an enlarged scale of Figure 1;
- Figure 3A: is a cross-sectional view of the unit device taken along line A-A in Figure 2;
- Figure 3B: is a cross-sectional view of the unit device taken along line B-B in Figure 2;
- Figure 4: is a layout of the gate-separated type unit device of Figure 2;
- Figure 5: illustrates one mode of wiring between gates positioned adjacent to each other in the lateral direction in the gate-separated type unit device in Figure 2;
- Figure 6: illustrates diagonal wiring between adjacent gates in the gate-separated type unit device in Figure 2;
- Figure 7: is a plan view of a D flip-flop constituted by two unit devices of the first embodiment of the present invention;
- Figure 8: is a schematic plan view showing an inner structure of a semiconductor chip of a conventional channelless-type gate array;
- Figure 9: illustrates an array of gate-separated type unit device of Figure 8;
- Figure 10: is a circuit diagram of the unit device of Figure 8;
- Figure 11: is an enlarged plan view of the unit device of Figure 8;
- Figure 12: shows an example of wiring between the gates positioned adjacent to each other in the lateral direction in the unit device of Figure 8;
- Figure 13: shows an example of wiring between the gates diagonally positioned in the unit device of Figure 8;
- Figure 14: is a circut diagram of a D flip-flop composed by MOSFETs; and,
- Figure 15: shows an example of wiring between two unit devices of Figure 8 to compose a D flip-flop.

### PREFERRED EMBODIMENTS OF THE INVENTION

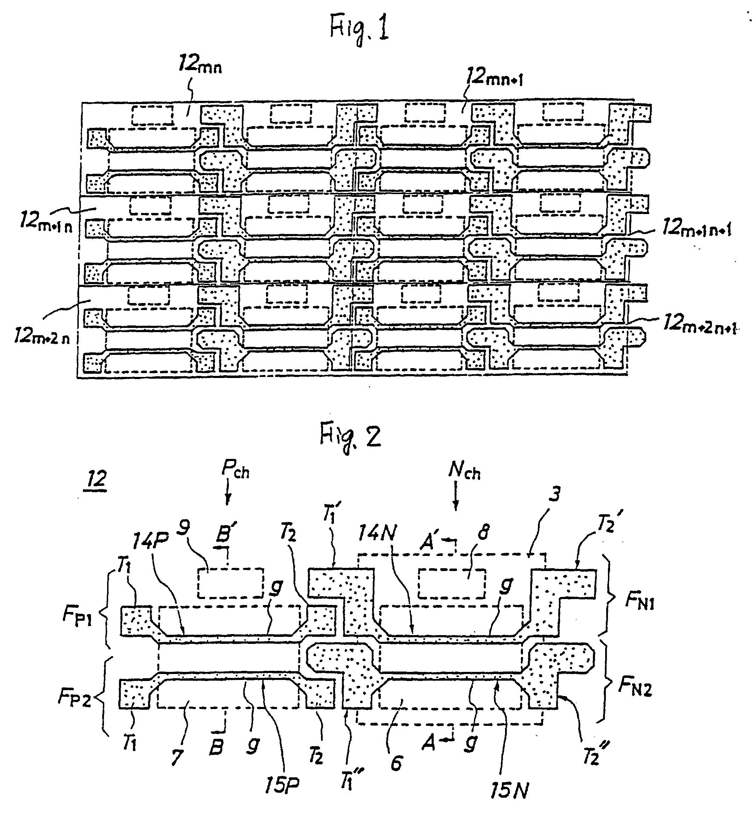

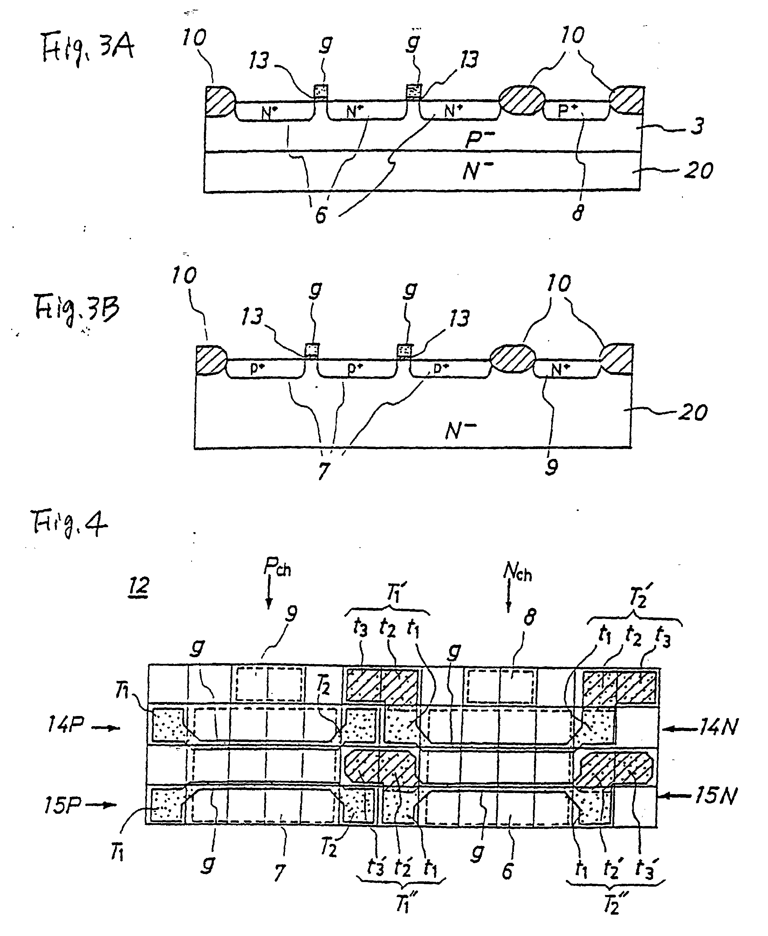

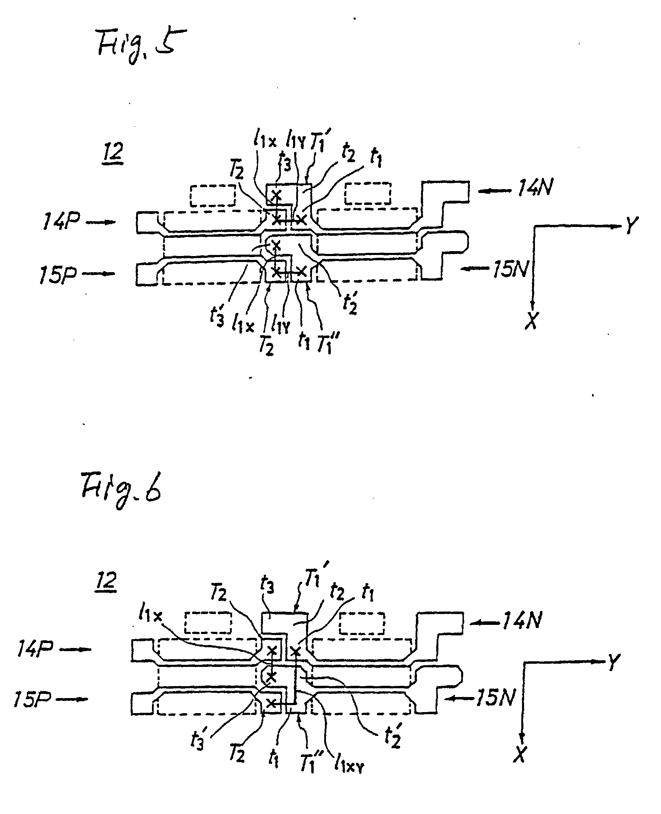

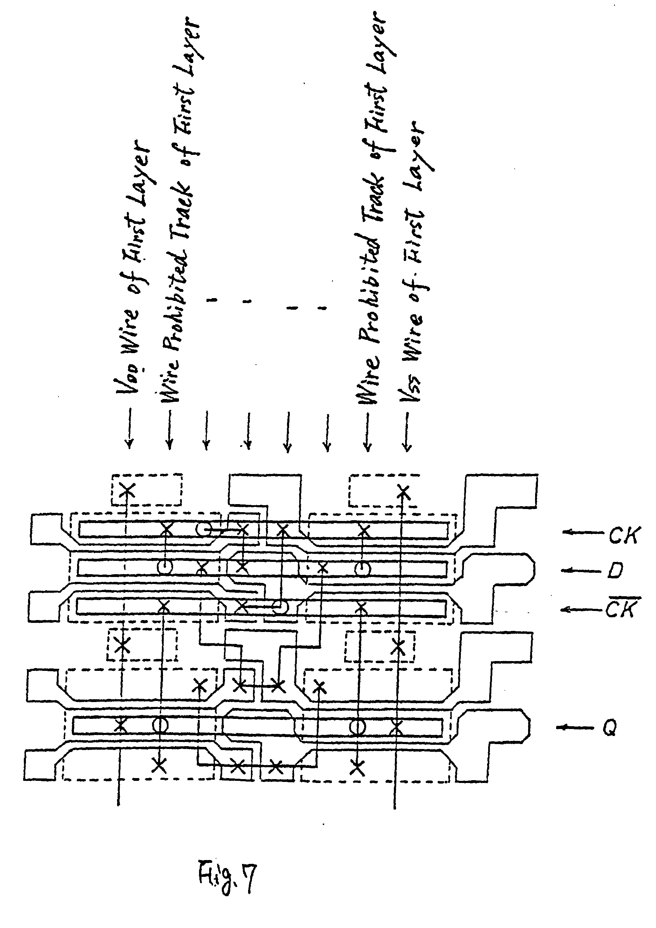

Figures 1 to 4 illustrate a first embodiment of the present invention. As shown by the drawings, a plurality of unit semicondutor devices 12 of gate-separated type are arranged along the longitudinal and lateral directions at the same intervals to form a matrix of the unit devices. Each of the unit devices 12 has a plane structure comprising a pair of N-channel MOSFETs (F _{N1}, F _{N2}) arranged parallel to each other and a pair of P-channel MOSFETs (F_{P1}, F _{P2}) arranged parallel to each other and positioned adjacent to the respective N-channel MOSFFETs. The region in which the N-channel MOSFETs are formed is provided with a square region of P well 3 by diffusing P-type impurities into an N-type silicon substrate 20 of low dense impurities. A pair of polysilicon gates 14N and 15N are formed in parallel with each other on the P-type well 3 via gate oxide film 13. A high dense N-type diffused region 6 is formed in a self-aligned manner by ion implantation of N-type impurities with utilizing the polysilicon gates 14N and 15N as masks, this region 6 being source or drain region. Adjacent to the high dense diffused region, a high dense P-type stopper 8 is formed by diffusion which is used for supplying voltage V _{SS} to the P well 3. In addition, oxide films 10 are deposited thickly and partially on the P-type well 3. Likewise, the region in which the P-channel MOSFETs (F _{P1}, F _{P2} ) are formed is provided with a pair of polysilicon gates 14P and 15P which are formed in parallel with each other on the substrate adjacent to the P well 3 via the gate oxide film 13. A high dense P-type diffused region 7 is formed in a self-aligned manner by ion implantation of P-type impurities with utilizing the polysilicon gates 14P and 15P as masks, this region 7 being source or drain region. Adjacent to the high dense diffused region, a high dense P-type stopper 9 is formed by diffusion which is used for supplying voltage V _{DD} to the N-type substrate 20. In addtion, oxide films 10 are deposited thickly and partially on the P-type well 3.

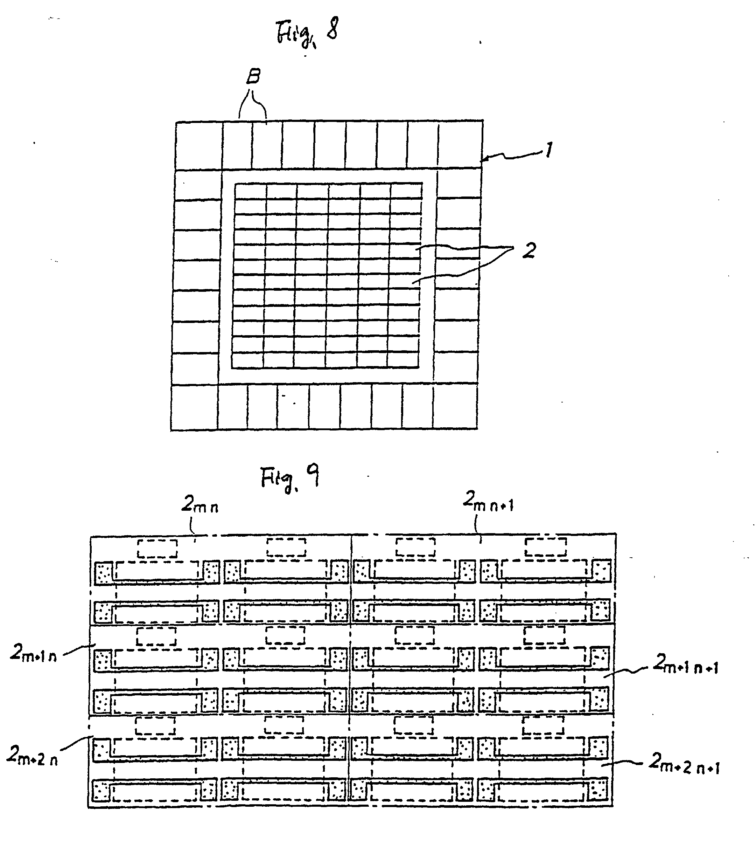

The polysilicon gates 14P and 15P are shaped to be a substantially flat U-shape and are arranged symmetrically. As shown in Figure 4, each of the polysilicon gates 14P and 15P comprises a narrow width gate electrode g of four-grid length and gate terminal portions T1 and T2 which are integrally connected to both ends of the gate electrode g and are of rectangular shape having an area of one-grid square. The gate terminal portions T1 and T2 have an area sufficient for a single wire connection, that is, for wiring via a single contact hole to form ohmic contact. The regions just below the gate electrodes g, g apart from each other by one-grid distance are for channel regions of four-grid width. Among those, the region between the gate electrodes g, g in the high dense N-type diffused region 7 is utilized as a common source or drain region for the two P-channel MOSFETs. These drain or source regions for the P-channel MOSFETs have four wire connecting positions arranged in the channel width direction, and the stopper 9 has two wire connecting positions arranged in the same direction.

The polysilicon gates 14N and 15N are formed at the positions the polysilicon gates 14P and 15P moved laterally by a predetermined distance. The gates 14N and 15N have a different shape from the gates 14P and 15P, that is, the gate 14N has a portion of the same shape as of the gate 14P and a portion denoted by oblique lines in Figure 4 integrally added to the former. In other words, the gate 14N comprises a narrow gate electrode portion g of about four-grid length and crank-shaped gate terminal portions T1' and T2' integrally connected to both ends of the gate electrode portion g. The terminal portion T1' adjacent to the gate 14P comprises a first wire connecting position t1 of one-grid square corresponding to the terminal portion T1 of the gate 14P, a second wire connecting position t2 of one-grid square extending from the first terminal position t1 in the channel length direction and a third wire connecting position t3 of one-grid square which is extended from the position t2 in the channel width direction towards the gate 14P and located adjacent to the terminal portion T1 of the gate 14P. The terminal portion T2' opposite to the terminal portion T1' comprises a first wire connecting position t1 of one-grid square corresponding to the terminal portion T2 of the gate 14P, a second wire connecting position t2 of one-grid square extending from the first terminal position t1 in the channel length direction and a third wire connecting position t3 of on-grid square which is extended outwardly from the position t2 in the channel width direction. The second and third wire connecting positions t2 and t3 denoted by oblique lines in Figure 4 are located on the same grid line on which the stoppers 8 and 9 are located. The gate 14N itself is shaped symmetrically with respect to the line passing through the center thereof in the channel width direction.

The gate 15N is provided with a terminal portion T1" adjacent to the gate 15P, the terminal portion T1" comprising a first wire connecting position t1 of one-grid square corresponding to the terminal portion T1 of the gate 15P, a second wire connecting position t2' of one-grid square extending from the first terminal position t1 in the channel length direction and a third wire connecting position t3' of one-grid square which is extended from the position t2' in the channel width direction toward the gate 14P and located between the terminal portions T2 of the respective gates 14P and 15P. The terminal portion T2" opposite to the terminal portion T1" comprises a first wire connecting position t1 of one-grid square corresponding to the terminal portion T2 of the gate 15P, a second wire connecting position t2' of one-grid square extending from the first terminal position t1 in the channel length direction and a third wire connecting position t3' of one-grid square which is extended outwardly from the position t2' in the channel width direction. The second and third wire connecting positions t2' and t3' denoted by oblique lines in Figure 4 are located on the grid line between the parallel gates g, g. The gate 15N itself is shaped symmetrically with respect to the line passing through the center thereof in the channel width direction. In addition, the wire connecting positions t2' and t3' of the gate 15N are formed to have the chamfered shape of the wire connecting positions t2 and t3.

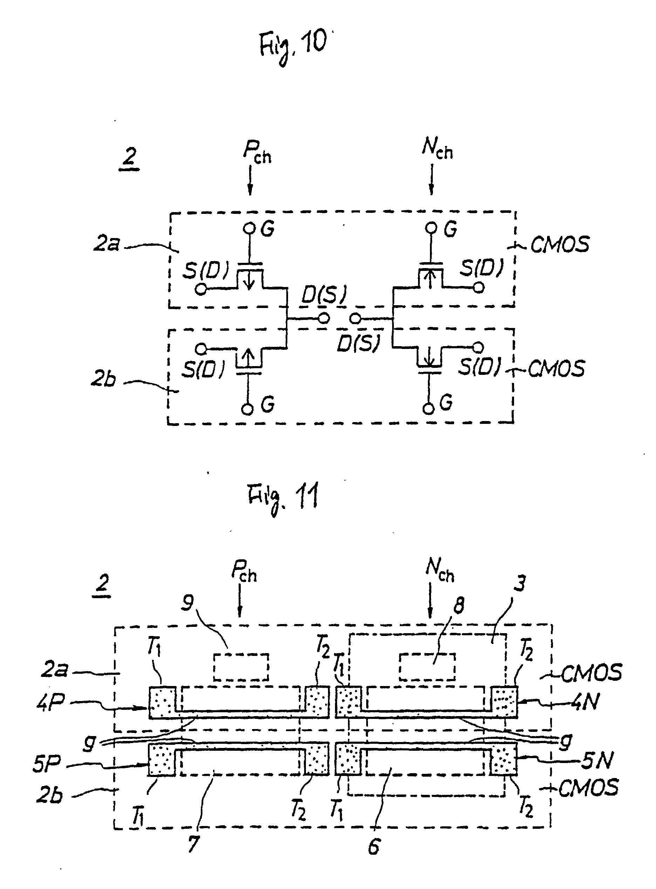

The terminal portions T2 and T2 of the gates 14P and 15P can be connected to the terminal portions T1' and T1" in the following two wiring manners as shown in Figure 5. A first wiring manner is such that the terminal portions T2 and T2 are connected via contact holes (shown by 'X') with the terminal portions T1' and T2' by means of an aluminum wire ℓ _{1Y} of the first layer arranged along Y grid direction. The other wiring manner is such that the terminal portions T2 and T2 are connected via contact holes (shown by 'X') with the terminal portions T1' and T1" at their third connecting positions t3 by means of an aluminum wire ℓ_{1X} of the first layer arranged in X grid direction normal to Y grid direction. Thus, where a pair of adjacent gate-separated type CMOSFETs in the same unit device are connected with each other to form a common gate, two ways of the shortest wiring can be obtained with utilizing only the wires of the first layer having one-grid length. This means that the wiring feasibility is extremely enhanced compared to the conventional devices. The space occupied by the unit device 12 of the present embodiment is four-grid long in X direction by twelve-grid wide in Y direction and so, is the same as that of the prior unit devices of Figure 11. The unit devices of the present embodiment are characterized by adding the second and third wire connecting positions t2, t3, t2' and t3' to the gates 14N and 15N designated by oblique lines in Figure 4 which are located in unused regions of the grid line in which the stoppers 8 and 9 and of the grid line in which the common region of the source or drain are situated. Therefore, increase in the area of the unit devices can be avoided in the present embodiment.

Next, the diagonal wiring of the gates in the unit device 12 can be carried out as shown in Figure 6, wherein the terminal portion T2 of the gate 14P is connected to the terminal portion T1" and the portion T2 of the gate 15P to the portion T1' of the gate 14N. In the illustrated diagonal wiring, the terminal portion T2 is connected to the adjacent terminal portion T1" of the gate 15N at its third wire connecting portion t3' by means of an aluminum wire ℓ _{1X} of the first layer arranged along the longitudinal grid line (X grid-direction), whereas the terminal portion T2 of the gate 15P is connected to the terminal portion T1' of the gate 14N at its third wire connecting position t1 by means of an aluminum wireℓ_{1XY} of the first layer arranged so that it passes on the first and second wiring positions t1 and t2' of the terminal portion T1' in this order. In the present embodiment, a space of three-grid length in X direction by two-grid width in Y direction is defined by the terminal portions T2 of the respective gate 14P and 15P, the terminal portion T1" of the gate 15N, and the first wire connecting positions t1 of the terminal portions T1" and T1' of the respective gates 15N and 14N, in which space the diagonal wiring among the gates can be perfomed by the aluminum wires of the first layer without utilizing aluminum wires of the second layer deposited on the first aluminum layer. The benefits obtained from using only the first aluminum layer are that wire prohibited tracks occurring due to the use of second aluminum layer can be avoided, which contributes to enhancement of the outer wiring feasibility. As shown in Figure 13, according to the prior wiring, it is inevitable to arrange the aluminum wiresℓ ₁₃ and ℓ ₂ of the first and second layers one on the other in the opposite directions and to arrange wires such as the aluminum wire ℓ ₁₂ to the extent on the gate electrodes g and so, the wires cannot be arranged within the space of three-grid length by two-grid width. In contrast, according to the present embodiment, since aluminum wires of the second layer do not need to be utilized and wires do not go over the gate electrodes g, the wiring length can be reduced. Therefore, the capacity and resistance caused by wiring can be reduced at the same time, and the inner wiring feasibility can be enhanced as well as the delayed time caused by the wiring can be reduced.

Figure 7 illustrates a D flip-flop comprised by the two unit semiconductor devices of the present embodiment, the flip-flop being the same as that of Figure 15. It should be noted in Figure 7 that the wiring length is extremely reduced and that no prohibited tracks of the second wires occur. The terminal portions T1', T2', T1" and T2" of the respective gate 14N and 15N are all provided with the second and third wire connecting positions. Alternatively, as is apparent from the wiring illustrated in Figure 6, unit devices without terminal portions T1', T2' and T2" of the respective gates 14N and 15N can be used to thereby enhance the inner and outer wiring feasibilities in comparison with those of the prior art unit devices.

## Claims

1. A semiconductor device comprising a plurality of unit semiconductor devices (12), each comprising a first insulated-gate type field-effect transistor (F_{P2}) of a first conductivity type and a second insulated-gate type field-effect transistor (F_{N2}) of a second conductivity type, said unit semiconductor devices and transistors being selectively connected by wires to one another to constitute a desired logic circuitry, wherein
said first and second transistors are disposed adjacent to each other,
said first transistor has a first gate electrode (15P) having a first gate terminal portion (T₂) on the side facing said second transistor and a second gate terminal portion (T₁) on the side remote from said second transistor,
said second transistor has a second gate electrode (15N) having a third gate terminal portion (T₁") adjacent to said first gate terminal portion and a fourth gate terminal portion (T₂") on the side remote from said first transistor, wherein
said third and fourth gate terminal portions each have first (t₁), second (t₂') and third (t₃') wire connecting portions integrally connected with each other,
the second gate terminal portion (T₁), one of source and drain regions of said first transistor, said first gate terminal portion (T₂), a first wire connecting portion (t₁) of said third gate terminal portion (T₁"), one of source and drain regions of said second transistor and a first wire connecting portion (t₁) of said fourth gate terminal portion (T₁") are arranged on a first straight line,
the other one of source and drain regions of said first transistor, the second and third wire connecting portions (t₂',t₃') of said third and fourth gate terminal portions (T₁", T₂") and the other one of source and drain regions of said second transistor are arranged on a second straight line parallel to said first line,
said first gate terminal portion (T₂) and said third wire connecting portion (t₃') of said third gate terminal portion are arranged on a third straight line perpendicular to said first and second lines,
the first and second wire connecting portions (t₁, t₂') of said third gate terminal portion are arranged on a fourth straight line parallel to said third line,
the first and second wire connecting portions (t₁, t₂') of said fourth gate terminal portion are arranged on a fifth straight line parallel to said fourth line, and
said third wire connecting portion (t₃') of said fourth gate terminal portion is arranged on a sixth straight line parallel to said fifth straight line and disposed on the side of said fifth straight line remote from said third and fourth straight lines.

2. The device of claim 1 wherein each unit semiconductor device (12) further comprises
a third insulated-gate type field-effect transistor (F_{P1}) of the first conductivity type and a fourth insulated-gate type field-effect transistor (F_{N1}) of the second conductivity type, wherein
said third transistor (F_{P1}) is disposed adjacent to the first transistor (F_{P2}) and said fourth transistor (F_{N1}) is disposed adjacent to the second transistor (F_{N2}) in the direction of said third and fourth lines,
said third transistor has a third gate electrode (14P) which is disposed in parallel to said first gate electrode (15P) and has a fifth gate terminal portion (T₂) on the side facing said fourth transistor,
said fourth transistor has a fourth gate electrode (14N) which is disposed in parallel to said second gate electrode (15N) and has a sixth gate terminal portion (T₁') adjacent to said fifth gate terminal portion, and
said fifth gate terminal portion (T₂) is arranged on said third straight line on the side of said third wire connecting portion (t₃') remote from said first gate terminal portion (T₂).

3. The device of claim 2 wherein said first and third transistors (F_{P2}, F_{P1}) have a common source or drain region and said second and fourth transistors (F_{N2}, F_{N1}) have a common source or drain region.

4. The device of any one of claims 1 to 3 wherein said gate terminal portions are connected integrally to and arranged in the same layer as the gate electrodes, respectively.

5. The device of claim 4 wherein said gate terminal portions are formed in regions other than source or drain regions of said transistors and are wider than said gate electrodes.

## Patentansprüche

1. Halbleiterbauelement mit einer Mehrzahl von Halbleiterbauelementeinheiten (12), von denen jede einen ersten Feldeffekttransistor (F_{P2}) mit isoliertem Gate eines ersten Leitfähigkeitstyps und einen zweiten Feldeffekttransistor (F_{N2}) mit isoliertem Gate eines zweiten Leitfähigkeitstyps aufweist und die Halbleiterbauelementeinheiten und Transistoren selektiv mit Drähten zur Bildung einer gewünschten logischen Schaltung miteinander verbunden sind, wobei
der erste und der zweite Transistor nebeneinander angeordnet sind,
der erste Transistor eine erste Gateelektrode (15P) mit einem ersten Gateanschlußabschnitt (T₂) auf der dem zweiten Transistor zugewandten Seite und einem zweiten Gateanschlußabschnitt (T₁) auf der von dem zweiten Transistor abgewandten Seite aufweist,
der zweite Transistor eine zweite Gateelektrode (15N) mit einem dritten Gateanschlußabschnitt (T₁") neben dem ersten Gateanschlußabschnitt und einem vierten Gateanschlußabschnitt (T₂") auf der von dem ersten Transistor abgewandten Seite aufweist, wobei
der erste und der vierte Gateanschlußabschnitt jeweils einen ersten (t₁), einen zweiten (t₂') und einen dritten (t₃') Drahtverbindungsabschnitt aufweisen, die einstückig miteinander verbunden sind,
der zweite Gateanschlußabschnitt (T₁), eine von Source- und Drainzonen des ersten Transistors, der erste Gateanschlußabschnitt (T₂), ein erster Drahtverbindungsabschnitt (t₁) des dritten Gateanschlußabschnitts (T₁"), eine von Source- und Drainzonen des zweiten Transistors und ein erster Drahtverbindungsabschnitt (t₁) des vierten Gateanschlußabschnitts (T₁") auf einer ersten geraden Linie angeordnet sind,
die andere von Source- und Drainzonen des ersten Transistors, der zweite und der dritte Drahtverbindungsabschnitt (t₂', t₃') des dritten und des vierten Gateanschlußabschnitts (T₁", T₂") und die andere von Source- und Drainzonen des zweiten Transistors auf einer zweiten geraden Linie parallel zur ersten Linie angeordnet sind,
der erste Gateanschlußabschnitt (T₂) und der dritte Drahtverbindungsabschnitt (t₃) des dritten Gateanschlußabschnitts auf einer dritten geraden Linie senkrecht zur ersten und zur zweiten Linie angeordnet sind,
der erste und der zweite Drahtverbindungsabschnitt (t₁, t₂') des dritten Gateanschlußabschnitts auf einer vierten geraden Linie parallel zur dritten Linie angeordnet sind,
der erste und der zweite Drahtverbindungsabschnitt (t₁, t₂') des vierten Gateanschlußabschnitts auf einer fünften geraden Linie parallel zur vierten Linie angeordnet sind, und
der dritte Drahtverbindungsabschnitt (t₃') des vierten Gateanschlußabschnitts auf einer geraden Linie parallel zur fünften geraden Linie auf deren von der dritten und der vierten geraden Linie abgewandten Seite angeordnet ist.

2. Bauelement nach Anspruch 1, bei dem jede Halbleiterbauelementeinheit (12) ferner umfaßt
einen dritten Feldeffekttransistor (F_{P1}) mit isoliertem Gate des ersten Leitfähigkeitstyps und einen vierten Feldeffekttransistor (F_{N1}) mit isoliertem Gate des zweiten Leitfähigkeitstyps, wobei
der dritte Transistor (F_{P1}) neben dem ersten Transistor (F_{P2}) angeordnet ist und der vierte Transistor (F_{N1}) neben dem zweiten Transistor (F_{N2}) in Richtung der dritten und der vierten Linie angeordnet ist,
der dritte Transistor eine dritte Gateelektrode (14P) besitzt, die parallel zur ersten Gateelektrode (15P) angeordnet ist und einen fünften Gateanschlußabschnitt (T₂) auf der dem vierten Transistor zugewandten Seite aufweist,
der vierte Transistor eine vierte Gateelektrode (14N) besitzt, die parallel zur zweiten Gateelektrode (15N) angeordnet ist und einen sechsten Gateanschlußabschnitt (T₁') neben dem fünften Gateanschlußabschnitt aufweist, und
der fünfte Gateanschlußabschnitt (T₂) auf der dritten geraden Linie auf der von dem ersten Gateanschlußabschnitt (T₂) abgewandten Seite des dritten Drahtverbindungsabschnitts (t₃') angeordnet ist.

3. Bauelement nach Anspruch 2, bei dem der erste und der dritte Transistor (F_{P2}, F_{P1}) eine gemeinsame Source- oder Drainzone besitzen und der zweite und der vierte Transistor (F_{N2}, F_{N1}) eine gemeinsame Source- oder Drainzone besitzen.

4. Bauelement nach einem der Ansprüche 1 bis 3, bei dem die Gateanschlußabschnitte einstückig mit den jeweiligen Gateelektroden verbunden und in derselben Ebene wie diese angeordnet sind.

5. Bauelement nach Anspruch 4, bei dem die Gateanschlußabschnitte in anderen Zonen als den Source- oder Drainzonen der Transistoren angeordnet und breiter als die Gateelektroden sind.

## Revendications

1. Dispositif à semi-conducteur comprenant une pluralité de dispositifs (12) à semi-conducteur élémentaires, comprenant chacun un premier transistor (F_{P2}) à effet de champ du type à grille isolée d'un premier type de conductivité et un deuxième transistor (F_{N2}) à effet de champ du type à grille isolée d'un second type de conductivité, les dispositifs élémentaires à semi-conducteur et les transistors étant connectés sélectivement par des conducteurs les uns aux autres pour constituer un circuit logique souhaité, dans lequel
les premier et deuxième transistors sont disposés en étant adjacents l'un à l'autre,
le premier transistor a une première électrode (15P) de grille ayant une première partie (T₂) formant borne de grille du côté faisant face au deuxième transistor et une deuxième partie (T₁) formant borne de grille du côté éloigné du deuxième transistor,
le deuxième transistor a une deuxième électrode (15N) de grille ayant une troisième partie (T₁") formant borne de grille voisine à la première partie formant borne de grille et une quatrième partie (T₂") formant borne de grille du côté éloigné du premier transistor, dans lequel
les première et quatrième parties formant borne de grille ont chacune des première (t₁), deuxième (t₂') et troisième (t₃') parties de connexion de conducteur connectées entre elles,
la deuxième partie (T₁) formant borne de grille, l'une des régions de source et de drain du premier transistor, la première partie (T₂) formant borne de grille, une première partie (t₁) de connexion de conducteur de la troisième partie (T₁") formant borne de grille, l'une des régions de source et de drain du deuxième transistor et une première partie (t₁) de connexion de conducteur de la quatrième partie (T₁") formant borne de grille sont disposées sur une première ligne droite,
l'autre des régions de source et de drain du premier transistor, la deuxième et la troisième partie (t₂', t₃') de connexion de conducteur des troisième et quatrième parties (T₁", T₂") formant borne de grille et l'autre des régions de source et de drain du deuxième transistor sont disposées sur une deuxième ligne droite parallèle à la première ligne,
la première partie (T₂) formant borne de grille et la troisième partie (t₃) de connexion de conducteur de la troisième partie formant borne de grille sont disposées sur une troisième ligne droite perpendiculaire à la première et à la deuxième lignes,
les première et deuxième parties (t₁, t₂') de connexion de conducteur de la troisième partie formant borne de grille sont disposées sur une quatrième ligne droite parallèle à la troisième ligne,
les première et deuxième parties (t₁, t₂') de connexion de conducteur de la quatrième partie formant borne de grille sont disposées sur une cinquième ligne droite parallèle à la quatrième ligne, et
la troisième partie (t₃') de connexion de conducteur de la quatrième partie formant borne de grille est disposée sur une sixième ligne droite parallèle à la cinquième ligne droite et disposée du côté de la cinquième ligne droite qui est éloignée des troisième et quatrième lignes droites.

2. Dispositif suivant la revendication 1, dans lequel chaque dispositif (12) élémentaire à semi-conducteur comprend en outre
un troisième transistor (F_{P1}) à effet de champ du type à grille isolée du premier type de conductivité et un quatrième transistor (F_{N1}) à effet de champ du type à grille isolée du second type de conductivité dans lequel
le troisième transistor (F_{P1}) est adjacent au premier transistor (F_{P2}) et le quatrième transistor (F_{N1}) est adjacent au deuxième transistor (F_{N1}) dans la direction des troisième et quatrième lignes,
le troisième transistor a une troisième électrode (14P) de grille qui est disposée parallèlement à la première électrode (15P) de grille et a une cinquième partie (T₂) formant borne de grille du côté faisant face au quatrième transistor,
le quatrième transistor a une quatrième électrode (14N) de grille qui est disposée parallèlement à la deuxième électrode (15N) de grille et qui a une sixième partie (T₁') formant borne de grille voisine à la cinquième partie formant borne de grille, et
la cinquième partie (T₂) formant borne de grille est disposée sur la troisième ligne droite du côté de la troisième partie (t₃') de connexion de conducteur qui est éloignée de la première partie (T₂) formant borne de grille.

3. Dispositif suivant la revendication 2, dans lequel les premier et troisième transistors (F_{P2}, F_{P1}) ont une région commune de source ou de drain et les deuxième et quatrième transistors (F_{N2}, F_{N1}) ont une région commune de source ou de drain.

4. Dispositif suivant l'une quelconque des revendications 1 à 3, dans lequel les parties formant borne de grille sont connectées respectivement aux électrodes de grille et disposées dans la même couche que celles-ci.

5. Dispositif suivant la revendication 4, dans lequel les parties formant borne de grille sont formées dans des régions autres que les régions de source ou de drain des transistors et sont plus larges que les électrodes de grille.
